Europäisches Patentamt

European Patent Office

Office européen des brevets

(19)

(11) Publication number: 0 166 261
A2

(12)

# EUROPEAN PATENT APPLICATION

(21) Application number: 85106685.2

(22) Date of filing: 30.05.85

(51) Int. Cl.⁴: H 01 L 29/78

(30) Priority: 27.06.84 US 625142

(43) Date of publication of application: 02.01.86
Bulletin 86/1

(84) Designated Contracting States: AT BE CH DE FR GB IT
LI LU NL SE

(71) Applicant: ENERGY CONVERSION DEVICES, INC.,
1675 West Maple Road, Troy Michigan 48084 (US)

(72) Inventor: Ovshinsky, Stanford R., 2700 Squirrel Rd.,
Bloomfield Hills, MI 48013 (US)
Inventor: Guha, Subhendu, 629 West Maple, Apt. 17,
Clawson, MI 48018 (US)
Inventor: Hack, Michael G., 1860 Axtell Rd., Apt. 3, Troy,
MI 48084 (US)
Inventor: Shur, Michael, 217 Janalyn Circle, Golden
Valley Minnesota 55416 (US)

(74) Representative: Müller, Hans-Jürgen, Dipl.-Ing. et al,
Müller, Schupfner & Gauger
Lucile-Grahn-Strasse 38 Postfach 80 13 69,
D-8000 München 80 (DE)

(54) Static field-induced semiconductor devices.

(57) There is disclosed a field effect transistor in which a charged body of material, formed with a fixed charge, is in field effect proximity to the channel region of the transistor. The channel region is formed of amorphous semiconductor material, and the field effect of the charged body shifts the Fermi level of the channel region without atomic impurity doping. According to another aspect of the invention a semiconductor device is disclosed which includes a first region of amorphous semiconductor material, and a field inducing layer, formed with a built-in charge, in field effect proximity to the first region so as to shift the Fermi level thereof. The device also includes a second region of material which has a different Fermi level than the material of the first region. The first and second regions are placed in contact to form a semiconductor junction device.

## TITLE MODIFIED
### see front page

PROXIMITY DOPED SEMICONDUCTOR DEVICES

FIELD OF THE INVENTION

This invention relates generally to improved semiconductor devices, and more particularly to such devices made of amorphous semiconductor materials.

BACKGROUND OF THE INVENTION

One purpose of ongoing research of both applicants and others, is to develop "proximity doped" disordered multilayered semiconducting materials. Proximity doping, which may also be termed "modulation doping" or "transfer doping", is a process whereby the electronic properties of a semiconductor layer are modified by the induction of an electric field therein and the bending of energy bands due to the proximity of said semiconductor layer to specifically designed superadjacent and/or subjacent layers. For example, proximity doping can be achieved by placing a body of intrinsic semiconductor material in close proximity to a field inducing layer which has a net electric charge. The electric field induced in the intrinsic

-2-

semiconductor material acts upon that material to shift its Fermi level relative to the energy levels of its conduction and valence bands without the introduction of dopant atoms into the semiconductor material. This field induced shift of the Fermi level has the effect of changing the number of electrons and holes in the semiconductor material, as would the introduction of atomic donor or acceptor impurities into that material, but it does not have the adverse effect, of introducing defect states as would the introduction of such impurities.

On another technological front, considerable work has been done to develop field effect transistors made of amorphous semiconductor material. For example, the assignee of the instant invention has filed patent applications relating to a plurality of different types of thin film transistors made from amorphous semiconductor materials. Such applications include U.S. Patent Application Serial No. 208,278, filed November 19, 1980, by Richard A. Flasck and Scott H. Holmberg, entitled "Thin Film Transistor"; U.S. Patent Application Serial No. 549,996, filed November 8, 1983, by Hellmut Fritzsche and Robert R. Johnson entitled "High Performance, Small Area Thin Film Transistor"; U.S. Patent Application Serial No. 549,979, filed November 8, 1983, by Vincent D. Cannella, Gregory L. Hansell and Zvi Yaniv entitled "Thin Film Transistor Having An Annealed Gate Oxide And Method Of Making Same"; and U.S. Patent Application Serial No. 590,836, filed March 19, 1984 by Zvi Yaniv, Vincent D. Cannella, Gregory L. Hansell and Mark E. Murray entitled "Improved Reduced Compacitance Narrow Channel Thin Film Transistor And Method Of Making The Same", the disclosures of all of which are incorporated herein by reference.

0166261

-3-

In such field effect transistors a channel region of amorphous material is placed in electrical series between a source and a drain electrode. A gate electrode is electrically insulated from the channel region. The gate is positioned so that when a certain threshold voltage is supplied to it, the resultant electrostatic potential in the channel region induces enough charge carriers into that region to make it conductive. Unfortunately, however the threshold voltage required to switch a channel region of substantially intrinsic amorphous semiconductor material from a substantially non-conducting state to a substantially conducting state is higher than desirable for many applications.

In the past, attempts have been made to decrease this threshold voltage by placing impurity doping atoms in the amorphous semiconductor material used in channel regions. But the reduction of threshold voltage resulting from such impurity doping has not been been as great as desired. This is because only a small proportion of the impurity atoms added to amorphous semiconductors for doping purposes create charge carriers as desired. Many of the impurity atoms only create defect states, that is, locations in the amorphous material at which holes or electrons can be trapped or taken out of conduction. These defect states have energies between the energy of the valence band in which holes conduct and the conduction band in which free electrons conduct. The presence of such a large number of defect states increases the change in gate voltage required to obtain a given change in charge carrier concentration in the channel region. This is because the non-conducting defect states tend to be filled by electrons before additional electrons are added to the conduction band, and tend to be emptied of electrons

-4-

before additional holes are added to the valence band. Thus, such defect states decrease the change in conductivity which results from a given change in induced voltage, decreasing the amplification and sensitivity of field effect transistors which use such impurity doped amorphous materials.

## SUMMARY OF THE INVENTION

According to one aspect of the present invention, a field effect transistor is provided of the type which includes a source, a drain, and a channel region of amorphous semiconductor material in which a conduction channel can be formed between the source and the drain. The transistor further includes a gate adapted, in response to an applied voltage, to induce a change in the conductivity of the channel region. In such a transistor, the invention provides the improvement of a field inducing body of material, formed with a built-in charge, in field effect proximity to the channel region, so as to shift the Fermi level of the channel region by means of field effect rather than by atomic impurity doping.

In alternate embodiments of the invention, the field inducing body can have either a positive or a negative built in charge, shifting the Fermi level to make the channel region either more n-type or more p-type. The field inducing body can be used to shift the Fermi level of the channel region either to reduce the gate voltage required to turn the transistor on, or to make the transistor substantially on without the application of any gate voltage, so that a gate voltage must actually be applied to turn the channel region off.

0166261

-5-

In a preferred embodiment of the invention, both the field inducing body and the amorphous semiconductor material in which the channel region is located are formed of layers of deposited material which are in contact with each other, and the built-in charge of the field inducing layer is formed in the creation of those layers. In certain preferred embodiments, the field inducing layer is made of an amorphous hydrogenated silicon carbide alloy, an electrical insulator, which, when formed in contact with the amorphous semiconductor material in which the channel region is located, attracts a negative built-in charge, tending to shift the Fermi level in the channel region to make that material more p-type. In other preferred embodiments the field inducing layer is made of an amorphous hydrogenated silicon nitride alloy, also an electrical insulator, which, when formed in contact with the amorphous semiconductor material in which its channel region is located, attains a positive built-in charge, tending to shift the Fermi level in the channel region to make that material more n-type. In other embodiments, the field inducing layer has atomic impurity dopants such as phosphorous or boron added to it to cause the charged layer to obtain an additional component of built-in charge by charge transfers with adjacent amorphous semiconductor material.

According to another aspect of the present invention, an electronic circuit is provided, of the type having two field effect transistors in which the gate of both transistors are responsive to a common input. Both transistors have either their source or drain connected to form a common output, and one transistors has either its source or drain connected to a relatively positive power supply, while the other transistor has either its source or drain connected to

-6-

a relatively negative power supply. The channel regions of the two transistors are selected so that a voltage supplied to the common input which turns one transistor on, will turn the other off. One aspect of the present invention is the inclusion in at least one of the two transistors of a field inducing body of material, formed with a built-in charge, in field effect proximity to the channel region of that transistor so as to shift the Fermi level of that channel region by means of a field effect rather than by atomic impurity doping.

In a preferred embodiment, the two transistors are both metal oxide semiconductor transistors, and one of them is an n-channel transistor and the other is a p-channel transistor, so the two transistors form a CMOS circuit. In the preferred embodiment, each transistor would have a field inducing body, or layer, of material formed with a built-in charge in field effect proximity to its channel regions so as to shift the Fermi level thereof by means of field effect rather than atomic impurity doping.

According to another aspect of the present invention a semiconductor device is provided which comprises a first region of material consisting essentially of an amorphous semiconductor material. The device further includes a first field inducing body of material, formed with a built-in charge, in field effect proximity to the first region, so as to proximity dope the first region by shifting the Fermi level thereof toward one band edge, either the conduction or valance band edge, by means of a field effect rather than by atomic impurity doping. The device also includes a second region of material which has its Fermi level positioned relatively further away

-7-

from the band edge toward which the Fermi level of the first region has been shifted. The first and second regions are in contact with each other so as to form a junction.

In a preferred embodiment of this aspect of the invention, the second region of material consists essentially of an amorphous semiconductor material and has a second field inducing body, located in field effect proximity to the second region, formed with a built in charge of a polarity opposite that of the first field inducing body. The built-in charge of the second field inducing body proximity dopes the second region by shifting the Fermi level thereof toward the band edge opposite that toward which the Fermi level of the first region is shifted. As a result, the junction between the first and second regions forms a p-n junction.

In another embodiment of this aspect of the invention, a variably chargeable body of material is located in field effect proximity to the first region. The variably chargeable body variably alters, by means of a field effect, the amount which the Fermi level in the first region is shifted toward a given band edge in the vacinity of the junction.

## BRIEF DESCRIPTION OF THE DRAWINGS

Figure 1 is a cross-sectional side view of a thin film field effect transistor embodying the present invention;

Figure 2A is a cross-sectional side view of a piece of amorphous semiconductor material in contact with a field inducing layer having a positive built-in charge, and Figure 2B is a diagram showing the

-8-

shifting of the Fermi level in the amorphous semiconductor material which results from the field effect proximity of the field inducing layer;

Figure 3A is a cross-sectional side view of a piece of amorphous semiconductor material in contact with a field inducing layer having a negative built-in charge, and Figure 3B is a diagram representing the shifting of the Fermi level in that amorphous semiconductor material which results from the field effect proximity of the field inducing layer;

Figures 4 through 8 are cross-sectional side views of thin film field effect transistors embodying alternative embodiments of the present invention;

Figure 9 is a circuit diagram of a standard CMOS electronic circuit;

Figure 10 is a cross-sectional side view of an electronic circuit embodying another aspect of the present invention and having the schematic circuit representation shown in Figure 9;

Figure 11 is a schematic diagram of an electronic circuit according to another aspect of the invention;

Figure 12 is a cross-sectional side view of another electronic circuit embodying the present invention;

Figure 13 is a cross-sectional side view of a thin film field effect transistor embodying another aspect of the present invention;

Figure 14A is a schematic cross-sectional side view of a semiconductor junction device embodying another aspect of the present invention, Figure 14B shows the energy levels of the conduction and valence band edges of the material in Figure 14A, and Figure 14C shows a corresponding prior art semiconductor junction device;

0166261

-9-

Figure 15 is a cross-sectional side view of an alternative embodiment of the semiconductor junction device of the present invention; and

Figure 16 is a cross-sectional side view of yet another embodiment of the semiconductor junction device of the present invention.

## DESCRIPTION OF THE PREFERRED EMBODIMENT

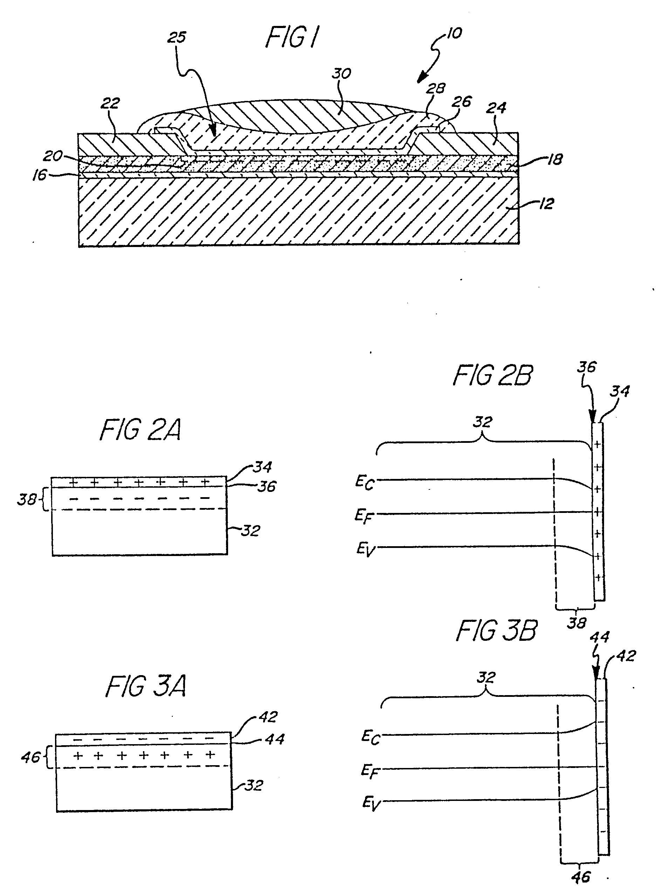

Referring now to Figure 1, a thin film field effect transistor 10 is shown which embodies the present invention. The transistor 10 is formed on a substrate 12, which can be formed, for example, from glass. Overlying substrate 12 is a thin field inducing layer 16. Overlying layer 16 is a layer 18 of deposited amorphous semiconductor material. By the term "amorphous" is meant an alloy or material which has long-range disorder, although it may have short or intermediate range order or even contain microcrystalline phases or some crystalline inclusions. Such material can include, for example, microcrystalline semiconductor materials. Layer 18 can, for example, be formed of an amorphous alloy of silicon, germanium, or silicon and germanium. Preferably, the amorphous semiconductor material of layer 18 is made of a substantially intrinsic amorphous semiconductor material, that is, of an amorphous semiconductor material without any significant concentration of impurity doping atoms. However, it should be noted that some intrinsic, or undoped, amorphous semiconductor materials have a Fermi level which is slightly closer to the conduction band than the valence band, thereby giving them a slight preponderance of n-type charge carriers over p-type carriers.

-10-

The field-inducing body, or layer, 16, is in contact with the amorphous semiconductor layer 18 and is made of a material, which is formed with a built-in charge. The field inducing body, or layer, 16, like the field inducing layers shown in the other figures of this application, can be comprised of an alloy of amorphous silicon including an element chosen from the group consisting essentially of carbon, hydrogen, nitrogen, fluorine and mixtures thereof. For example, if it is desired that a field inducing layer have a negative charge to make an adjacent layer of amorphous silicon alloy have p-type characteristics, the field inducing layer can be formed of an amorphous hydrogenated silicon carbide alloy having the general formula amorphous Si:C:H. Such a layer can be deposited from a glow discharge decomposition of a gaseous mixture of silane, methane and hydrogen. Similarly if it is desired that the field inducing layer have a positive charge to make a layer of an amorphous silicon alloy have n-type characteristics, the field inducing layer can be made of an amorphous hydrogenated silicon nitride alloy having the general formula amorphous Si:N:H. Such an alloy can be deposited from a glow discharge decomposition of a gaseous mixture of silane, amonia and hydrogen. Layers 16 and 18 can be deposited on substrate 12 using the method and apparatus described in U.S. Patent Application Serial No. 558,959, filed December 7, 1983 and entitled "Semiconducting Multilayered Structures And Systems And Methods For Synthesizing The Structures And Devices Incorporating The Structures". This U.S. Patent application, 358,959, the disclosure of which is incorporated herein by reference, describes a method of producing semiconducting multilayered structures made of amorphous semiconductor material.

-11-

An important aspect of the present invention is the use of a negatively charged layer, such as Si:C:H, as the material of a field inducing layer for proximity doping in a semiconductor device. This is important because it is more difficult to obtain high quality p-type amorphous semiconductor materials then it is n-type through impurity doping. Intrinsic amorphous semiconductor materials, such as Si:H and Si:F:H tend to have more defect states in the bottom half of the energy gap between the conduction and valence band edges than in the top half of that energy gap. As a result it is more difficult to shift the Fermi level downwards to make such materials p-type than it is to shift it upward to make them n-type. Thus, heavier doping is required to make intrinsic amorphous materials have a p-type characteristic than to make them have an n-type characteristic. In the prior art, when such heavy p-type doping was attempted by impurity doping, a large number of additional defect states were created, thereby decreasing some of the electrical characteristics of the amorphous semiconductor material, and making it unsuitable for many semiconductor device applications. The use of negatively charged field inducing layers makes it possible to create an amorphous semiconductor material with p-type characteristics without such deleterious impurity doping.

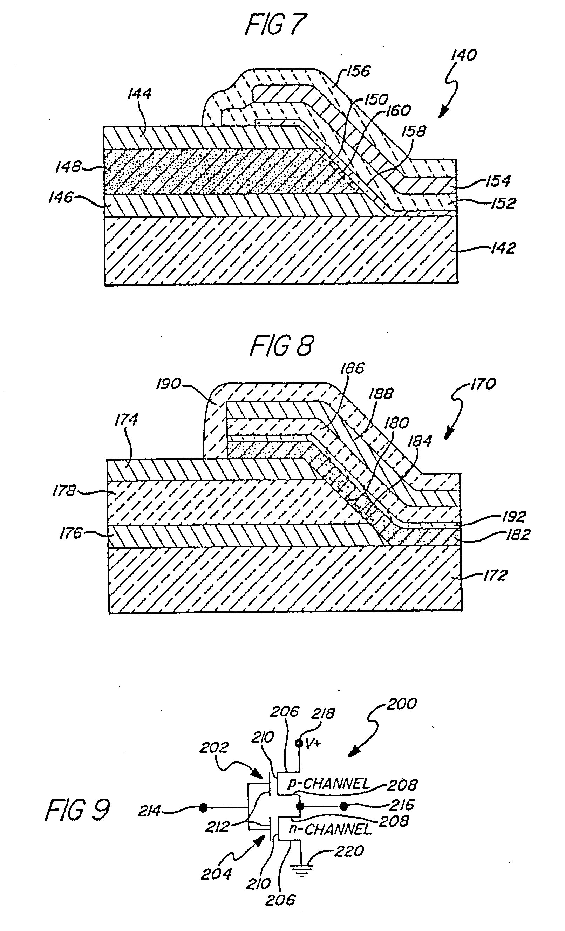

Disposed over layer 18 are a source 22 and a drain 24, which are both made of metal in the embodiment shown. Care should be taken that both source 22 and drain 24 form an ohmic contact with the amorphous semiconductor material of layer 18. Since the substantially intrinsic material of layer 18 has a slight n-type characteristic, it is best that the source and drain electrodes be made of low work function metals, such as magnesium, chromium or

-12-

aluminum. For an even better ohmic contact a layer of n+ amorphous semiconductor material should be placed between such low work function metals and layer 18, in a manner similar to that shown in Figure 5, discussed below.

Source 22 and drain 24 are separated by a gap 25. A channel region 20 is located in the portions of layer 18 which extends across the gap 25 between the source 22 and the drain 24. A conducting channel can be formed in this channel region during the operation of the field effect transistor 10. Because the channel region 20 is located in layer 18, that layer can be referred to as the channel layer.

A second field inducing layer 26 is disposed over the gap 25, so as to be in field effect proximity with the channel region 20. The field inducing layer 26 can be made of the same material as the field inducing layer 16, and it cooperates with the layer 16 to shift the Fermi level of the amorphous semiconductor material in the channel region 20.

The field inducing layers 16 and 26 are made of materials which are insulators. Amorphous alloys of silicon carbide and silicon nitride can both be considered insulators, since they have a conductivity lower than that of intrinsic amorphous silicon:hydrogen alloys. It is important that field inducing layer 26, which is connected to both source 22 and drain 24 not be a conductor, otherwise it would electrically short the channel region 20.

Overlying the field inducing layer 26 is a layer of gate insulator 28, which can be formed, for example, from a silicon oxide ($SiO_x$). Then over the gate insulator 28 a gate 30 is formed of a metal such as aluminum.

-13-

The thin film transistor 10 operates in a manner similar to that of traditional thin film amorphous semiconductor field effect transistors. A voltage is placed across the source 22 and the drain 24, but the conductivity of the amorphous semiconductor material in the channel layer 18, is sufficiently low that substantially no current will flow between the source and drain in the absence of a voltage applied to gate 30. However, when a sufficient voltage is applied to the gate 30, the field generated by the charge on gate 30 shifts the Fermi level in the channel region 20, attracting to the channel region charge carriers of a polarity opposite that of the voltage on gate 30. The charge carriers induced into the channel region 20 greatly increase its conductivity, thereby increasing the current flow between the source 22 and the drain 24.

A novel aspect of the present invention is the use of field inducing layers, such as layer 26 and 16, to shift the Fermi level of the channel region in a field effect thin film amorphous semiconductor transistor. Figures 2A, 2B, 3A and 3B, show the effect of such field inducing layers upon the Fermi level of an adjacent amorphous semiconductor material. Figure 2A shows a proximity structure comprised of a layer 32 of substantially intrinsic amorphous silicon alloy, such as Si:F:H or Si:H similar to layer 18 of Figure 1, placed in contact with a charged field inducing layer 34, similiar to layer 26 of Figure 1. Between layers 32 and 34 is a junction 36 at which the two layers meet. Since layer 34 has a positive charge, it induces a field into the layer 32, which increases the concentration of negative charge carriers, or free electrons, in a portion 38 of layer 32 adjacent layer 34.

-14-

Figure 2B shows how the energy level $E_C$ of the conduction band edge and the energy level $E_V$ of the valence band edge of the intrinsic layer 32 are shifted relative to the Fermi level $E_F$ of that layer by the positive charge on layer 34. The relative position of the Fermi level $E_F$ between the conduction band edge $E_C$ and the valence band edge $E_V$ varies as a function of the relative number of free electrons to holes. The excess of free electrons attracted by the positively charged layer 34 into region 38 shifts the Fermi level $E_F$ in that region closer to $E_C$ and further from $E_V$. This shift in the Fermi level $E_F$ relative to $E_C$ and $E_V$ is shown in Figure 2B by the bending of the energy levels $E_C$ and $E_V$ rather than by the bending of the Fermi level $E_F$ because, as is well known in the semiconductor arts, at equilibrium the Fermi level is flat. The excess of free electrons in the region 38, and the corresponding shift in the Fermi level $E_F$ closer to $E_C$ and further from $E_V$, gives the semiconductor material in that region the characteristics of an n-type semiconductor. However, because the shift in Fermi level is achieved by proximity doping rather than atomic impurity doping, it is achieved without the high number of defect states in layer 32 which would result from impurity doping.

Figures 3A and 3B are identical to Figures 2A and 2B except that the charged field inducing layer 42 in Figures 3A and 3B has a negative, rather than a positive charge, which induces a positive charge, or an excess of holes, in the region 46 of the intrinsic layer 32 near the junction 44 with the field inducing layer 42. As a result, the Fermi level $E_F$ in that region is shifted closer to the valence band edge $E_V$, and further from the conduction band edge $E_C$.

-15-

Since the Fermi level $E_F$ is flat at equilibrium, the shift in the Fermi level relative to $E_C$ and $E_V$ results in a bending of $E_C$ and $E_V$, as shown in Figure 3B. The shifting of the Fermi level closer to $E_V$ and the excess of holes caused by the negatively charged field inducing layer 42 gives region 46 the characteristics of a p-type semiconductor. This proximity doping is achieved without the high number of defect states which would be required to obtain a similar number of excess holes by means of atomic impurity doping.

The charge on the field inducing layers 34 and 42 is called a built-in charge because it is a charge built-in to those layers at the creation of the device of which they are part. Under intended operating conditions the built-in charge is retained by the field inducing layers during the useful life of the devices of which they are part. It is not yet clearly understood what causes the built-in charge to accumulate on field inducing layers formed of materials such as amorphous alloys of Si:C:H or Si:N:H. It has been found, however, that when a layer of such material and a layer of an amorphous silicon hydrogen alloy or amorphous silicon:fluorine:hydrogen alloy are deposited, one in contact with the other, from glow discharge decomposition, the built-in charge is formed in the creation of such layers.

One theory is that the built-in charge formed in or on the field inducing layer is caused by charge carriers trapped at the formation of the field inducing layer in deep traps located within the material of that layer or at its interface with the amorphous semiconductor layer. Deep traps are usually formed by defects, such as dangling bonds or atomic vacancies, which can trap free electrons or holes. They have energy levels located deep in the middle of

-16-

the gap between the conduction and valence bands. As a result, a large amount of energy is required to extricate electrons or holes caught with such traps. In fact, depending on the depth of the trap, the average amount of time required for a carrier to escape can vary from microseconds to many years. Thus, it is possible that the apparently permanent built-in charge observed on field inducing layers of the type discussed above is actually comprised of charge captured in deep traps which is slowly discharging, but is doing so at a rate too slow to be readily measurable.

It is also possible, however, that the built-in charge observed on such field inducing layers results from other causes. For example, it has been suggested that the built-in charge results from the fact that the Fermi level in the material of such field inducing layers is located at an energy level different from that in the adjacent intrinsic amorphous semiconductor. If that is the case, when the two layers are placed in contact during their creation, diffusion would cause electrons to flow between the field inducing layer and the adjacent intrinsic semiconductor layer to equalize the Fermi levels of the two materials. The net result would be that the field inducing layer develops a built-in charge, and the intrinsic semiconductor material attains an opposite charge. Another possibility is that when the field inducing layer, or its interface with a layer of amorphous semiconductor, is deposited, the atoms solidify into place in ionic form with an overall net electric charge. It is also possible that the built-in charge results from a combination of the above mentioned factors.

0156261

-17-

In alternative embodiments of the invention the field inducing layers used to shift the Fermi level of the channel region are formed of materials known to have a Fermi level different from that of the semiconductor materials of their associated channel regions. As a result, a semiconductor junction is formed between each such field inducing layer and the semiconductor material in which its associated channel region is located. Electrons flow across this junction so as to equalize the Fermi levels in both its sides, creating a charge on each side of the junction. Thus such a field inducing layers acquires its built-in charge and the semiconductor material of the channel region has its Fermi level shifted. Suitable materials for use in such field inducing layers include doped amorphous semiconductors such as amorphous Si:H or Si:F:H alloys doped with either boron or phosphorus atoms.

It should be noted, that many doped amorphous semiconductors are electrical conductors relative to the amorphous semiconductors often used in the channel regions of transistors. As a result, care should be taken that relatively conductive doped field inducing layers do not form an electrical short across the channel region of such transistors. Thus relatively conductive field inducing layers should not be placed in contact with the source and drain, as is field inducing layer 26 of Figure 1, but rather should be spaced from the source and drain, as is field inducing layer 16 in Figure 1.

When an intrinsic amorphous semiconductor material of a transistor has its Fermi level shifted by a field inducing layer, the operating characteristics of that transistor are changed. For example, a transistor of the type shown in Figure 1 normally operates by having a voltage placed on gate

-18-

30 which shifts the Fermi level of its channel region 20 sufficiently close to either the conduction band or the valence band to generate enough electrons or holes, respectively, to make that channel region conductive. By use of a field inducing layer such as layers 26 and 16 of Figure 1, the Fermi level can be shifted closer to either the conduction or valence band in the absence of such an applied voltage, reducing the amount which a gate voltage, when applied, has to shift the Fermi level to turn the transistor on. In other words, the field inducing layer reduces the threshold voltage which must be applied to gate 30 to turn on transistor 10.

Alternatively, by making the field inducing layers 26 and 16 have enough built-in charge, the Fermi level of channel region 20 can be shifted sufficiently close to either the conduction band or valence band so that the channel region 20 is substantially conducting in the absence of any voltage applied to gate 30. When this is the case, the transistor will be normally on, and a voltage will have to be applied to gate 30 to shift the Fermi level back toward the center of the gap between the conduction and valence bands, to turn the transistor off.

One way to increase the strength of the built-in charge on a field inducing layer is by adding impurity dopants to the materials of such layers. As is stated above, materials such as amorphous alloys of silicon nitride and silicon carbide naturally form a built-in charge when layers of such material are formed in contact with amorphous silicon alloys such as Si:F:H and Si:H. Such materials may be termed intrinsically charging materials since they form such built-in charge when used in the intrinsic form, that is, when used without the addition of any impurity

-19-

dopants. However, impurity doping atoms can be added to the intrinsically charging material of a field inducing layer. When this is done the built-in charge formed has not only a significant component resulting from the properties of the intrinsically charging material, but also an additional significant component resulting from charge transfer with a adjacent layer of amorphous semiconductor material caused by the presence of such impurity doping atoms. If it is desired to make the built-in charge more negative, the impurity doping atoms could include elements such as boron, which tend to form negative ions when placed in semiconductor materials. Conversely, if it is desired to make the built-in charge more positive, elements such as phosphorus, which tend to form positive ions, could be used.

Another way to increase the shift in the Fermi level of an intrinsic amorphous semiconductor channel region is to place two field inducing layers in close proximity to that channel region, as is shown in Figure 1 by the use of layers 16 and 26.

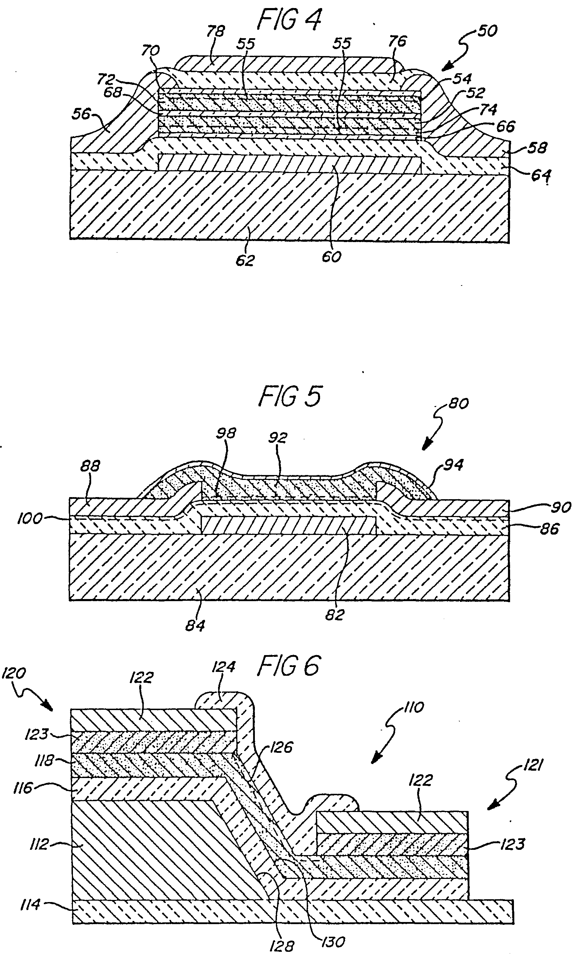

Referring now to Figure 4, a thin film field effect transistor 50 representing another embodiment of this invention is shown. Transistor 50 has a plurality of channel layers 52 and 54, each having a channel region 55 in which a conductive channel can be formed between a source 56 and a drain 58. The thin film transistor 50 is formed by placing a first gate electrode 60 upon a substrate 62 using conventional photolithographic means. Then a layer of gate insulator 64 is placed on top of the gate, again by photolithographic means. Then an alternating series of layers, consisting of field inducing layer 66, amorphous semiconductor layer 52, field inducing layer 68, amorphous semiconductor layer 54, and field inducing layer 70, is placed on top of the gate

0166261

-20-

insulator 64 by the method described in the above mentioned U.S. Patent Application Serial No. 558,959. Then this multilayered structure is etched to cut generally opposing verticle sides 72 and 74 against which the metal source and drain contacts 56 and 58 can be disposed by photolithographic techniques. The source 56 and drain 58 should be made of a metal which forms an ohmic contacts with the amorphous semiconductor material of layers 52 and 54. Once the source and drain 56 and 58 have been deposited, another layer of gate insulator 76 can be placed over the top of the multilayered structure, and then a metal gate electrode 78 can be placed on top of layer 76.

The transistor 50 operates in a manner substantially similar to that of transistor 10 shown in Figure 1. The field inducing layers 66, 68 and 70 operate to shift the Fermi level of the amorphous semiconductor material contained in layers 52 and 54, and, thus, to alter the amount of gate voltage which has to be applied to gates 60 and 78 to either turn the transistor on or off. One of the major advantages of a transistor such as transistor 50, shown in Figure 4, over transistor 10, shown in Figure 1, is that, because transistor 50 has a plurality of current conduction layers 52 and 54, it is capable of passing more current. If it is desired to make a proximity doped transistor according to the present invention capable of switching even larger amounts of current than that shown in Figure 4, a transistor having more than two vertically arrayed channel layers is formed. In such a transistor each channel layer is formed adjacent to a field inducing layer, and one or more insulated gates are sandwiched between the plurality of channel layers.

-21-

Referring now to Figure 5, a thin film transistor 80 is shown. The general configuration of transistor 80 is similar to that of the transistors described in the above mentioned U.S. Patent Application Serial No. 590,836.

The transistor 80 is formed by placing a gate 82 upon a transparent substrate 84, which can be formed, for example, of glass. A relatively transparent gate insulator 86 is placed over the gate and a layer of photoresist, not shown in Figure 4, is placed over the insulator 86. Light is transmitted through the substrate 84, so all but the portion of the photoresist directly above the gate 82, is exposed. The exposed photoresist is removed, leaving the gate insulator 86 covered by a portion of exposed photoresist immediately above gate 82. Then a layer of metal is placed down over the oxide layer 86 and the unexposed photoresist. The unexposed photoresist, and the metal on top of it, are removed by etching, leaving two separated portions of the deposited metal layer, one of which forms the source 88 of the transistor, and the other which forms the drain 90. A layer of amorphous semiconductor 92 is placed down over the gap between the source 88 and the drain 90. Then a thin field inducing layer 94, approximately 10 to 100 angstroms thick is placed over the amorphous layer 92.

In operation, when a voltage is applied to a gate 82 it induces an excess of charge carriers in the channel region, shown by the dotted lines 98. This allows conduction between the source 88 and the drain 90. The presence of the field inducing layer 94 shifts the Fermi level in the amorphous semiconductor material of layer 92. The shift either reduces the threshold voltage required for gate 82 to turn on the

-22-

channel 98, or causes the channel 98 to be normally on, requiring a voltage on gate 82 to deplete the channel region of carriers, and turn the transistor off.

A major advantage of transistors, such as that shown in Figure 5, is that because there is little overlap between their gate and their source or drain, the capacitance between those electrodes is minimized. This has the beneficial effect of increasing the frequency response of such transistors.

In the embodiment of the invention shown in Figure 5, the field inducing layer 94 is on the opposite side of the layer of amorphous semiconductor material 92 from the gate insulator 86. In alternative embodiments of the invention, however, a field inducing layer 100, indicated with a dotted line in Figure 5, could be placed on top of the gate insulator 86, either in replacement of, or in addition to, the field inducing layer 94.

Referring now to Figure 6, a thin film transistor 110 according to another embodiment of the invention is shown. The thin film transistor 110 has a configuration substantially the same as that described in the above mentioned U.S. Patent Application Serial No. 549,979.

A gate 112, comprised of metal, is placed upon a substrate 114. A gate oxide 116 is deposited over the gate 112, and then layer of amorphous semiconductor material 118 is deposited over the gate insulator 116. Once that is done, a source 120 and a drain 121, each comprised of a metal layer 122 on top of a layer 123 of doped semiconductor, are placed over the amorphous semiconductor material 118, as described in the above mentioned U.S. Patent Application Serial No. 549,979. The doped semiconductor 123 provides a good ohmic contact between the metal 122 of source 120

-23-

and drain 121 and the layer 118 of amorphous semiconductor material. The metal 122 can be, for example, aluminum or chromium, and the doped semiconductor 123 is preferably an n-type amorphous silicon alloy including fluorine.

One of the advantages of the thin film transistor 110 shown in Figure 6 is that the gate insulator layer 116 is placed down before the amorphous semiconductor layer 118. This is a great advantage because it enables the gate insulator 116, which is formed of an oxide, to be annealed, at a temperature of about $400^{\circ}$C, greatly increasing its insulative properties. Such a temperature is sufficiently high that it would destroy the conductive properties of the layer 118 of amorphous semiconductor material if such an annealing process were conducted after that layer had been put in place.

After layer 118 and source 120 and drain 121 have been deposited, a field inducing layer 124 is placed down over the gap between source 120 and drain 121. This field inducing layer 124 has the effect of shifting the Fermi level in the channel region 126 of the layer 118, so as to either decrease the amount of threshold voltage required to turn the transistor on, or to cause the transistor to normally be on and to reduce the amount of voltage required to turn it off.

As is stated in U.S. Patent Application Serial No. 549,979, another advantage of a thin film transistor having the structure shown in Figure 6 is that the channel region 126 between source 120 and drain 122 can be made very narrow, since the length of that channel region is determined largely by the thickness of gate 112. This is because the gate 112 has a first non-coplanar surface 128, which is non-coplanar with respect to the surface of the substrate 114. Similarly, the gate insulator 116 has

-24-

a second non-coplanar surface 130 over the first non-coplanar surface 128. The channel region 126 basically extends across the second non-coplanar surface 130, and, as is shown in the above mentioned U.S. Patent Application Serial No. 549,979, the presence of these non-coplanar surfaces enable the source 120 and the drain 122 to be placed in very close proximity by means of angled deposition of the materials from which source 120 and drain 122 are made.

Referring now to Figure 7, a thin film transistor 140 is shown which has a configuration substantially as described in the above mentioned U.S. Patent Application Serial No. 208,278. Transistor 140 is formed on a substantially horizontal substrate 142 and is comprised of a plurality of substantially horizontal layers 144, 146 and 148, which are vertically arrayed with respect to the substrate 142 and to each other. The horizontal layers include a metal layer 144 forming the source of transistor 140, a metal layer 146 forming its drain, and a channel layer 148 formed of amorphous semiconductor material between the source and drain layers. As is shown in Figure 7, a portion of the edges of the layers 144, 146 and 148 form a noncoplanar surface 150 with respect to the substrate 142. The gate insulator 152 overlies at least a portion of the non-coplanar surface, and a metal gate 154 is placed over the gate insulator. In addition a field oxide 156 can be placed over the gate 154.

The transistor 140 is formed with a field inducing layer 158 between the amorphous semiconductor material of layer 148 and the gate insulator 152. This layer is placed in field effect proximity with the amorphous semiconductor material in the channel region 160, which extends between the source 144 and the drain 146. As a result of the charge on layer 158, the Fermi level in the channel region 160 is shifted to either reduce the threshold voltage required to turn the transistor on, or to cause the transistor to be normally on and to require that a voltage be applied to turn it off.

One of the major advantages of the transistor shown in Figure 7 is that its channel region 160 can be made very short. This is because the length of the channel region is determined by the thickness of layer 148, and because present deposition techniques enable such layers to be made in very small thicknesses.

Referring now to Figure 8, a thin film field effect transistor 170 is shown which has a configuration similar to that shown in the above mentioned U.S. Patent Application Serial No. 549,996. Transistor 170 is formed on a substantially horizontal substrate 172 and is comprised of a plurality of horizontal layers 174, 176, and 178, vertically arrayed with respect to the substrate 172 and with respect to each other. The horizontal layers include a metal layer 174 forming the source of transistor 170, a metal layer 176 forming its drain, and an electrically insulating layer 178 between the source layer 174 and the drain layer 176. The edges of the layers 174, 176 and 178 form a non-coplanar surface 180 with respect to the substrate 172. A channel layer 182 of amorphous semiconductor material overlies the non-coplanar surface 180 between the source 174 and the drain 176 so as to be able to form a current conduction channel therebetween in a channel region 184. A gate insulating layer 186 is placed over the channel layer 182, and a gate layer 188 is placed over the gate insulator layer. Finally the entire set of layers comprising the channel, gate insulator and gate layers can be covered by a field oxide 190.

-26-

According to the present invention a field inducing layer 192 is placed between the gate insulator 186 and the channel layer 182. The field inducing layer 192 is placed in field effect proximity with the amorphous semiconductor material of the channel region 184 to shift the Fermi level of the amorphous semiconductor material in that channel region so a smaller voltage will be required to turn the transistor on, or so that the transistor will normally be on and so that a voltage will have to be applied to turn it off.

Referring to Figure 9, an electronic circuit 200 of a complementary metal oxide semiconductor, or CMOS, type is schematically shown. The circuit has two field effect transistors 202 and 204, each having a two current path electrodes, a source 206 and a drain 208. Each transistor further includes a channel region of amorphous semiconductor material 210 and a gate 212. The gate 212 is adapted, in response to an applied voltage, to induce a change in the conductivity of its corresponding channel region. The gates of both transistors 202 and 204 are connected to a common input 214. The drains 208 of both transistors are connected to form a common output 216. The source 206 of transistor 202 is connected to a relatively positive voltage supply 218, and the source 206 of the other transistor 204 is connected to a relatively negative voltage supply 220. The channel regions 210 of two transistors 202 and 204 are made so that a common gate voltage supplied to those transistors will turn one of the transistors on while turning the other off.

In the embodiment shown in Figure 9, transistor 202 has a p-type channel and transistor 204 has an n-type channel. When a low voltage, such as 0 volts, is supplied to input 214, the low voltage turns on the p-type channel of transistor 202, since the relatively negative voltage on its gate attracts positive charge carriers in its p-type channel. However, the same low voltage supplied to the gate of transistor 204 turns off that transistor's n-type channel, since n-channel transistors require a positive gate voltage to induce electrons into their channel regions so as to make them conductive. Thus the top transistor 202 turns on and the bottom transistor 204 turns off. This causes the high voltage supplied at input 218 to be passed through transistor 202 to the output 216, and it causes the low voltage at contact 220 to be isolated from the output 216. Conversely, when a high or relatively positive voltage is supplied to common input 214, it turns the p-channel transistor 202 off, isolating the positive voltage contact 218 from the output 216, and it attracts negative carriers to the n-channel of transistor 204, turning that transistor on, and thus connecting the output 216 to the low voltage at the contact 220. Thus, with either a high or low input signal, when one of the two transistors is on, the other is off, and the output 216 will be connected either to the high voltage contact 218 or to the low voltage contact 220, but not to both. As a result, very little current flows between the high voltage input 218 and the low voltage input 220, except when the circuit changes state. This is one of the major advantages of CMOS circuits. This low power consumption makes CMOS very useful for battery powered applications, where it is particularly important to save power. CMOS circuitry is also useful in applications in which it is desired to pack a large amount of circuitry into a small area without overheating the circuitry due to excess power dissipation.

-28-

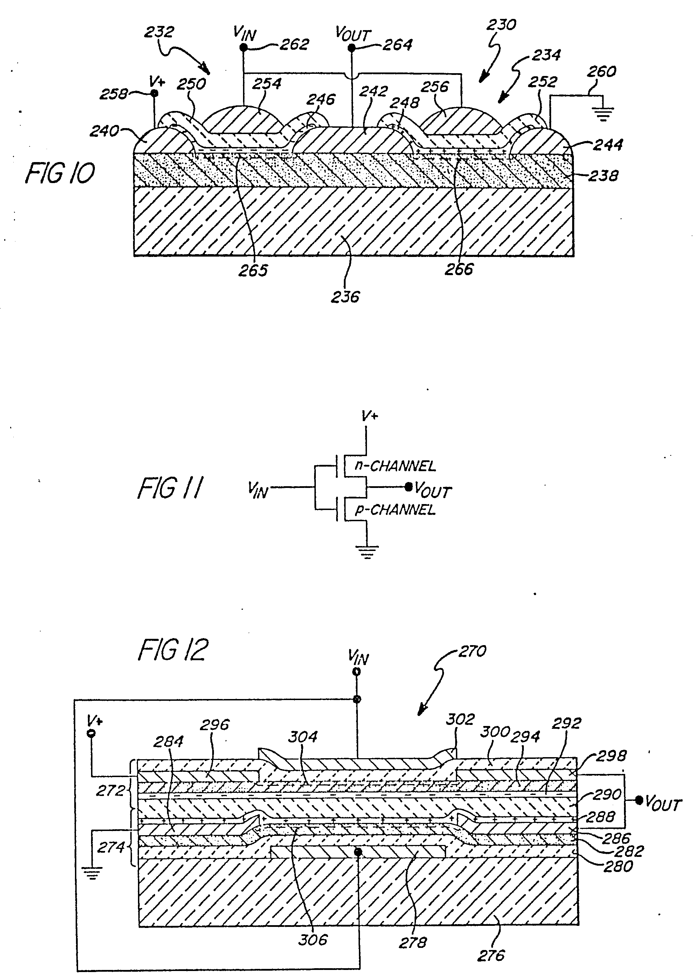

Referring now to Figure 10, a CMOS circuit 230, is shown having the circuit description of Figure 9, and embodying the present invention. The circuit 230 is comprised of two transistors 232 and 234 constructed upon a common substrate 236. The circuit 230 is constructed by placing a layer 238 of amorphous semiconductor material upon substrate 236. Then, by using photolithographic techniques, a source 240, a common drain 242 and second source 244, all made of metal, are placed upon layer 238. Once this has been done, a thin field inducing layer 246, having a negative built-in charge, is placed in contact with the amorphous semiconductor material of that portion of layer 238 which extends between source 240 and drain 242 of transistor 232. Similarly a field inducing layer 248, having a positive built-in charge, is placed in contact with the amorphous semiconductor material in that portion of layer 238 between source 244 and drain 242 of transistor 234. Gate insulating layers 250 and 252 are placed over the field inducing layers 246 and 248, respectively. Then gate electrodes 254 and 256 are placed over the gate insulating layers 250 and 252, respectively. The source 240 is connected to a positive voltage supply 258, and the source 244 is connected to a ground 260. The gates 254 and 256 are connected to a common input 262, and the common drain 242 is connected to an output 264. The negatively charged field inducing layer 246 causes the channel region 265 of the transistor 232 to have a p-type characteristic, since its negative fixed charge tends to increase the concentration of holes in that channel region. Conversely, the positively charged field inducing layer 248 increases the number of electrons in the channel region 266 of the second transistor 234, making that channel region have n-type

0166261

-29-

characteristics. Thus the field inducing layers 246 and 248 decrease the threshold required to make transistors 232 and 234 develop a conducting p-channel and a conducting n-channel, respectively. As a result, transistor 232 has a p-type channel region and transistor 234 has an n-type channel region, and the circuitry 230 has substantially all the characteristics of the circuit diagram in Figure 9.

In the past, it has been difficult to make p-type amorphous semiconductor materials, required for CMOS circuitry, by means of atomic impurity doping without creating a large number of defect states. As stated above, such defect states interfere with the induction of charge carriers by an electrostatic field, as is required for the operation in field effect transistors. The number of defect states in impurity dopant p-type amorphous semiconductors such as amorphous Si:H and Si:F:H is usually greater than that in n-type materials. This is because such amorphous semiconductors, when undoped, tend to have more defect states in the bottom half of the energy gap than on the top half, and thus substantially more doping impurity atoms, which create additional defects, are required to shift the Fermi level down so as to make such materials p-type than is required to shift the Fermi level up so as to make them n-type. A great advantage of the present invention is that its use of proximity doping makes it possible to create p-channel amorphous semiconductor transistors which have satisfactory conduction characteristics. This in turn, makes it possible to make satisfactory amorphous semiconductor CMOS circuitry, reducing the power consumption of such amorphous circuitry and increasing the amount of such circuitry which can be placed in a small area without overheating.

0166251

-30-

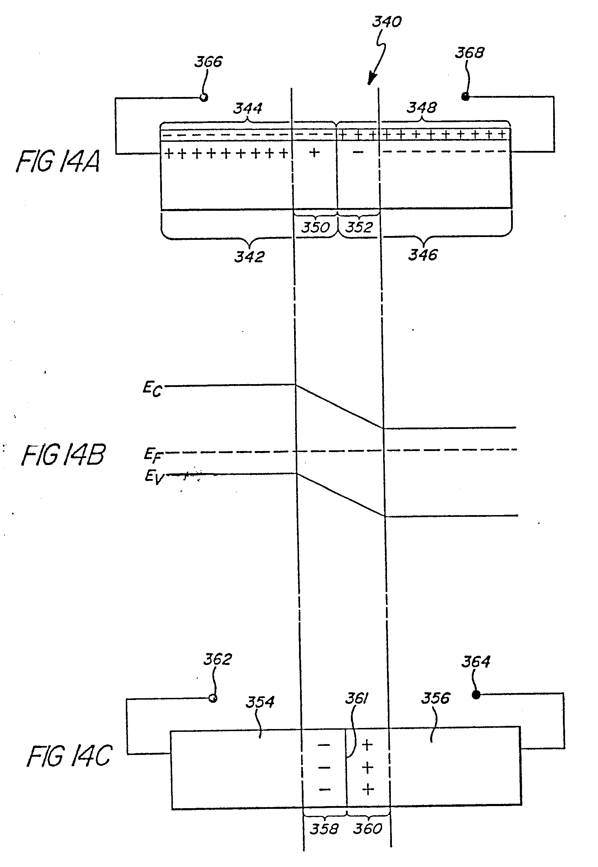

Referring now to Figure 11, a CMOS circuit of the type which operates in the depletion mode is shown in schematic form. This circuit is substantially identical to that shown in Figure 9, except that the channel regions of its two transistors operate in the depletion mode. This means that the two transistors are each normally on, and that a voltage has to be supplied to their gates to turn them off. However since the channel of one transistor operates in the n-type depletion mode and the channel of the other operates in the p-type depletion mode, a voltage which turns one off will leave the other on, and thus the device operates with all the benefits normally attributed to CMOS circuitry, e.g., low power dissipation. In operation, the n-channel shown in Figure 11 requires a relatively negative voltage to turn it off, whereas the p-channel transistor requires a positive voltage to turn it off. Therefore, if a relatively low voltage is supplied to the common input $V_{in}$ shown in Figure 11, that low voltage will turn the n-channel transistor off, and will leave the p-channel transistor on, thereby connecting the output to the ground through the p-channel transistor. Similarly, if a relatively high voltage is supplied to the common input, it will leave the n-channel transistor on, but will turn the p-channel transistor off, thereby connecting the output $V_{out}$ to the positive input. Thus the circuit shown in Figure 11 operates in a manner similar to that of the circuit of Figure 9, but with a signal output of the opposite polarity.

The circuit shown in Figure 11 is manufactured in a manner similar to that shown in Figure 10, except that the field inducing layer 246 in transistor 232 has a built-in positive charge sufficiently strong to make the channel region 265

-31-

conducting in the absence of a voltage on gate 254. Similarly the field inducing layer 248 of transistor 234 of Figure 10 has a built-in negative charge sufficiently strong to cause the channel region 266 to be a conducting in the absence of a voltage on gate 256. In addition, dopant impurities can be added to the channel regions 265 and 266 to aid in the shifting of their Fermi level so they will be normally conducting.

Referring now to Figure 12, a CMOS circuit 270 is shown, which has its two complementary transistors 272 and 274 both made of thin film material, with one transistor 272, located on top of the other 274. The CMOS circuit 270 has the schematic description shown in Figure 9. The gate 278 of transistor 274 is formed on a substrate 276 by photolithographic means. A layer of oxide material 280 is deposited on top of gate 278 to insulate it from subsequently deposited layers. A layer of amorphous semiconductor material 282 is deposited over gate insulator 280. On top of layer 282 metal source electrode 284 and metal drain electrode 286 are formed by photolithographic means. A thin, field inducing layer 288 made of a material, such as an amorphous hydrogenated silicon carbide alloy, which will have a positive built-in charge when formed in conjunction with the amorphous semiconductor material of layer 282. At this point, the construction of transistor 274 has been substantially completed. The next step is to deposit a relatively thick layer 290 of insulating oxide to electrically separate the field effect transistor 274 from the field effect transistor 272 deposited on top of it.

Once the oxide layer 290 has been put down, a field inducing layer 292 made of a material which will form a negative built-in charge when formed in contact

-32-

with a layer of amorphous silicon alloy is deposited. For example, an amorphous hydrogenated silicon carbide alloy is a suitable material for such a field inducing layer. Then a layer 294 of amorphous semiconductor material is deposited on top of the field inducing 292. Next metal source electrode 296 and metal drain electrode 298 are formed on top of the amorphous semiconductor layer 294 by photolithographic means. Once the source and drain 296 and 298 have been formed, a layer 300 of gate insulating material, such as an oxide is formed over them. Then a gate 302 is formed by photolithographic means over the channel region 304 which extends between the source 296 and the drain 298.

To make the CMOS circuit 270 operate it is necessary to connect the source electrode 296 of the top transistor 272 to a positive voltage supply such as $V_+$, to connect the source 284 of the bottom transistor 274 to a relatively negative voltage supply, such as ground, to connect the drains 298 and 286 of both transistors together to a common output $V_{out}$, and to connect the gates 302 and 278 of both transistors to a common input $V_{in}$. Once configured in this manner the circuit 270 functions in the same manner as the circuit shown in Figures 9 and 10 above. The field inducing layer 288 of transistor 274 shifts the Fermi level in the channel region 306 extending between the source and drain of transistor 274, making the originally intrinsic semiconductor material of that channel region behave as an n-type semiconductor in which electrons are the majority carrier. Similarly the field inducing layer 292 of transistor 272 shift the Fermi level of the amorphous

-33-

semiconductor material in the channel region 304 of transistor 272, causing that channel region to behave as a p-type semiconductor in which the majority carriers are holes.

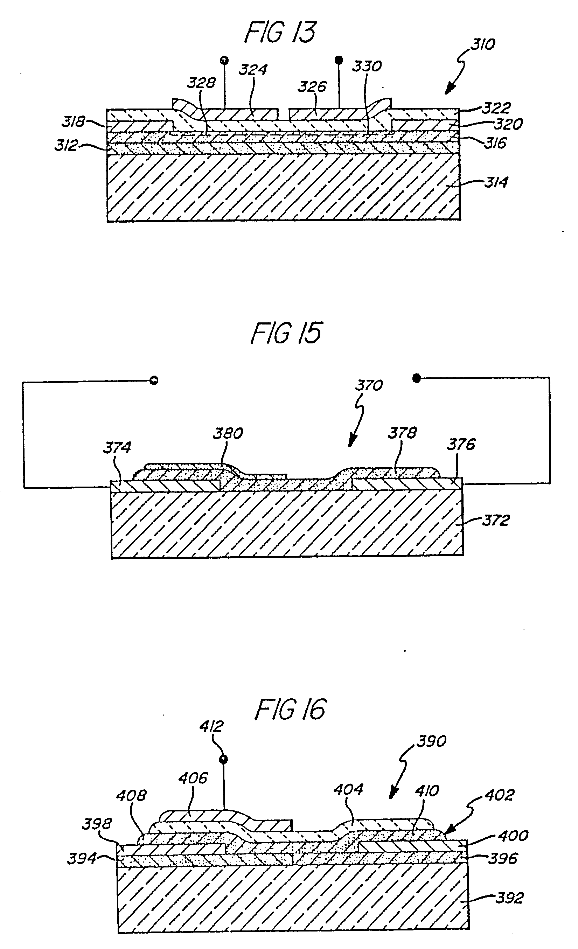

Referring now to Figure 13, a field effect transistor 310 is shown which embodies another aspect of the present invention. The transistor 310 is formed by depositing a thin field inducing layer 312 on top of a substrate 314, which can be formed of a material such as glass. The field inducing layer 312 is formed of a material, such as an amorphous hydrogenated alloy of silicon carbide or silicon nitrogen, discussed above, which will form a built-in charge when formed in contact with a layer of an amorphous silicon:hydrogen or silicon:fluorine:hydrogen alloy. Next a layer 316 of such an amorphous silicon alloy is deposited in contact with the field inducing layer 312. Then source and drain electrodes 318 and 320 are formed on top of the amorphous semiconductor layer 316 by photolithographic means. A layer of gate insulating oxide 322 is deposited on top of the source and drain electrodes 318 and 320, and over the portion of the amorphous semiconductor layer 316 which extends between them. Next two separate variably chargeable gate electrodes 324 and 326 are formed over the portion of the amorphous semiconductor layer 316 which extends between the source and drain electrode 318 and 320. The gate electrode 324 is positioned to induce a field capable of shifting the Fermi level in a first portion 328 of the channel layer 316. The second gate electrode 326 is positioned to induce a field capable of shifting the Fermi level in a second portion 330 of the channel layer 316. The two portions 328 and 330

-34-

of the channel layer 316 are positioned to slightly overlap, so that together the gates 324 and 326 can shift the Fermi level in a channel region that extends all the way between the source 318 and the drain 320.

A device having the configuration shown in Figure 13 can be operated in either an enhancement or a depletion mode. In the enhancement mode, the built-in charge on the field inducing layer 312 is made strong enough to shift the Fermi level in the channel region comprised of portions 328 and 330 of layer 316 toward either the conduction or valence band, but not so close toward either such band as to make the channel region conducting in the absence of voltages applied to both gate 324 and 326. Thus, in the enhancement mode the transistor 310 is normally off, and voltages must be supplied to both electrodes 324 and 326 to attract conducting charge carriers into both the channel portions 328 and 330 and to complete a conducting channel all the way between source 318 and drain 320. Thus, when a transistor having the structure shown in Figure 13, is designed to operate in the enhancement mode, it operates as an AND circuit, in which the device will remain off unless a threshold voltage is applied to both of its gate electrodes.

Alternatively, the device having the structure shown in Figure 13 can be made to operate as a depletion mode transistor if the conduction channel between its source 318 and drain 320 is normally on and if a voltage must be applied to its electrodes 324 and 326 in order to deplete that channel region of conducting charge carriers, and thus turn the transistor off. The channel regions can be made to have a normally conducting characteristic by making a very strong built-in charge on the field inducing layer 312. In addition, impurity doping atoms can be

-35-

added to the amorphous semiconductor material of channel layer 316 to help shift the Fermi level thereof so as to make the channel region normally conducting.

When the transistor 310 is operated in the depletion mode, the transistor will normally be on, unless a threshold voltage sufficient to deplete a portion 328 or 330 of the channel region is applied to either gate 324 or 326, respectively. Thus, the device of the Figure 13, when constructed to operate in the depletion mode, operates as a NOR circuit, which is turned off whenever a threshold voltage is applied to either of its two electrodes.

In Figure 13 there are only two variably chargeable gate electrodes shown in the channel region between the source 318 and the drain 320. However, it will be clear to those skilled in the art that three or more such variably chargeable gate electrodes may be placed in series across such a channel region so as to make a three or more input AND or NOR gate.

Referring now to Figure 14A, a schematic representation of a semiconductor device 340 according to another aspect of the present invention is shown. The semiconductor device 340 is formed of a first region 342 consisting essentially of an amorphous semiconductor material, such as an amorphous silicon:hydrogen alloy or an amorphous silicon:fluorine:hydrogen alloy. The device 340 further includes a first field inducing body or layer 344, formed with a built-in charge, located in field effect proximity to the first region 342. For example, to produce a field inducing body which has a positive built-in charge, such as the field inducing body 344 shown in Figure 14A, a thin layer of an amorphous hydrogenated alloy of silicon nitride can be used. The built-in charge of the first field inducing

-36-

body 344 proximity dopes a layer of semiconductor material in the first region parallel to the field inducing layer 344. It does so by shifting the Fermi level in the semiconductor material of the proximity doped layer toward one of the band edges, either the conduction or the valence band edge, by means of field effect rather than by atomic impurity doping. In Figure 14A the positively charged field inducing layer 344 shifts the Fermi level of the material in region 342 toward the conduction band, increasing the number of electron charge carriers in that region and thus making it have n-type semiconductor properties.

The device 340 further includes a second region 346 of material which has its Fermi level further away from the band edge toward which the material of the first region 342 has had its Fermi level shifted than the material of that first region. In the device 340 the Fermi level in a layer of the semiconductor material in the second region 346 parallel to a second field inducing body, or layer, 348 is shifted toward the valence band edge by means of that second field inducing body or layer 348. The field inducing body 348 is formed with a built-in negative charge and is placed in field effect proximity to the material of the second region 346. In the embodiment of the invention shown in Figure 14A the material of both the first and second regions 342 and 346 are formed of the same continuous layer of amorphous semiconductor material. However, since the amorphous semiconductor material in the proximity doped layer of region 342 has been proximity doped to form an n-type material and the proximity doped layer of region 346 has been proximity doped to be a p-type material, a p-n semiconductor junction is formed at the boundary between the two proximity doped layers. This p-n junction extends in a direction shown in

-37-

Figure 14A so as to influence the conduction of current which lies within and runs parallel to the proximity doped layers induced by the field inducing layers 344 and 348.

Referring now to Figures 14B and Figures 14C, the operation of the device 340 will be described. Figure 14B shows the energy levels of the conduction band edge $E_C$ and the valence band edge $E_V$ relative to Fermi level $E_F$ in the amorphous semiconductor material of the regions 342 and 346. As stated above, the Fermi level in the region 342 is shifted toward the level of the conduction band edge $E_C$ and the Fermi level in the region 346 is shifted toward the level of the valence band edge $E_V$. However, since the Fermi level is flat at equilibrium, the conduction band edge $E_C$ and the valence band edge $E_V$ have to bend in the portions 350 and 352 of the semiconductor material near the junction between regions 342 and 346. This bending of the conduction and valence bend edges shown in Figure 14B correspondes to that which exists in a normal p-n junction diode of the type shown in Figure 14C.

As is well known in the prior art, when a junction is made between two semiconductor materials having different Fermi levels, current will tend to pass through the junction more easily in one direction than in the other. Take, for example, a p-n junction. An n-type material is normally comprised both of an excess of free electron relative to holes and of a non-conducting, positive charge which tends to shift the Fermi level toward the conduction band so as to create such an excess of free electrons. Similarly a p-type semiconductor material normally is comprised both of an excess of holes relative to free electron and of a non-conducting, negative charge which tends to shift the Fermi level toward the

-38-

valence band edge so as to create such an excess of holes. In impurity doped semiconductor materials such non-conducting charge is formed by charged doping impurity ions distributed throughout the semiconductor material. In proximity doped semiconductors such non-conducting charge is formed by the built-in charge on field inducing layers.

When a junction is formed between a p-type and an n-type material, either impurity doped or proximity doped, the tendency toward randomness causes the relative excess of electrons in the n-type material to diffuse into the p-type material and the relative excess of holes in the p-type material to diffuse into the n-type material. However, this diffusion leaves the non-conducting charge near the junctions of such materials uncovered, creating a region, such as regions 350 and 358 in Figure 14A and 14C, respectively, of positive potential in the n-type material near the junction, and a region, such as regions 352 and 360 in Figure 14A and 14C, respectively, of negative potential in the p-type material near the junction. The field created by these charged regions creates a potential barrier which prevents diffusion of electrons from the n-type material and holes from the p-type material across the p-n junction unless those carriers have an energy greater than that of the potential barrier. The field created by such charged regions also creates a voltage induced, or drift, current in a direction opposite such diffusion current. At equilibrium, the drift current is equal to the diffusion current.

A p-n junction has rectification properties because if a voltage is applied across its junction which increases the field across it, the barrier to diffusion will be increased, decreasing the amount of such diffusion exponentially. However, such an

-39-

increase in the voltage across the junction will have a much smaller effect upon the drift current . As a result, such a diode operates as a reverse biased diode, in which the substantially only current is a small reverse current due to field induced drift. However if a voltage is applied in the opposite direction, so as to decrease the uncovered non-conducting charge in the regions near the junction, the barrier to diffusion across the junction will be decreased, greatly increasing the amount of diffusion current. In such a condition the junction is considered to be forward biased, and the amount of current it conducts is increased substantially. Thus, it can be seen that a p-n junction operates as a rectifier.

The proximity doped p-n junction shown in Figure 14A, operates similarly to the impurity doped p-n junction shown in Figure 14C even though the non-conducting charges which shift the Fermi levels in Figure 14A are placed in field inducing layers 344 and 348, rather than being distributed throughout the semiconductor material of the device, as in the case in Figure 14A. When the excess electrons in the proximity doped n-type material 342 and the excess holes of the p-type material 346 diffuse across the junction, a portion of the electrostatic charge on the field inducing layers 344 and 348 is left uncovered, creating a field which produces rectification in a manner similar to that in which rectification is created by the field of the uncovered ionic doping impurities in regions 358 and 360 of Figure 14C.

Referring now to Figure 15, a cross-sectional side view a semiconductor junction device using proximity doping according to the present invention shown. The junction device 370 is comprised of a substrate 372, which could be formed of a material

-40-

such as glass. Upon the substrate 372 a source electrode 374 and a drain electrode 376 are formed of metal by traditional photolithographic techniques. Then a layer 378 of amorphous semiconductor material, such as an amorphous silicon:hydrogen alloy, is deposited between the source 374 and drain 376. Next a field inducing body, or layer, 380 is deposited over a portion of the layer 378 extending from the source 374 to a point located part way between the source 374 and the drain 376.

The region of amorphous semiconductor material under the field inducing body 380 will have its Fermi level shifted. For example, as is shown in Figure 15 the field inducing layer 380 has a negative charge, such as can be achieved by depositing a layer of an amorphous hydrogenated alloy of silicon carbide. As a result, the portion of layer 378 beneath the field inducing layer 380 will have positive charge induced into it, making it a p-type semiconductor. Thus, a junction is created between a p-type semiconductor in the portion of the layer 380 below the field inducing layer 380 and the portion of layer 370 which is not covered by that field inducing layer. Because of the difference of Fermi levels between the substantially intrinsic amorphous semiconductor material contained in the region 378 and the p-type amorphous semiconductor material under the field inducing layer 380, the energy of the conduction and valence band edges will be bent at the junction between those two regions and that junction will have rectifying properties.

Referring now to Figure 16 a semiconductor junction device 390 according to another aspect of the invention is shown. The device 390 is formed on a substrate 392, which can be formed of material such as glass. Using photolithographic techniques a first

-41-

field inducing layer 394 is deposited upon the substrate 392, and then a second field inducing layer 396 is formed adjacent to the layer 394 upon the substrate 392. After that, two electrodes 398 and 400 are formed over the field inducing layers 394 and 396, respectively, so as not to cover the junction between those two field inducing layers. Then a layer 402 of amorphous semiconductor material, such as an amorphous silicon:hydrogen alloy, is deposited so as to extend between the electrodes 398 and 400 and so as to be in contact with the field inducing layers 394 and 396. Once this has been completed, a layer 404 of an insulating oxide is deposited on top of the layer 402. Then a variably chargeable body of material 406, preferably an electrode formed of metal, is placed on top of the insulating layer 404, so as to extend between the electrode 398 and the junction between the field inducing layers 394 and 396.

As is shown in Figure 16 the field inducing layer 394 has a negative charge, which can be formed by using a material such as an amorphous hydrogenated alloy of silicon carbide. This induces a positive charge into the region 408 of the amorphous semiconductor material of layer 402, making the material of that region a p-type semiconductor. Conversely, the field inducing layer 396 has a positive built-in charge, which can be formed by using a material such as an amorphous alloy of silicon nitride. This induces a negative charge into the region 410 of the layer 402, causing that material to have n-type characteristics. As a result, rectification will occur at the junction 412 formed between the two regions 408 and 410. The electrode 406 is located so as to be in field effect proximity with the p-type region 408 of the layer of amorphous semiconductor material 402.

-42-

As the amount of charge supplied to the electrode 406 through an electrical contact 412 is varied, the amount and direction in which that electrode shifts the Fermi level in the region 408 is correspondently varied. This makes it possible to effectively increase or decrease the p-type nature of the region 408, and thus alter the rectification characteristics of the junction 412.

The proximity doped amorphous semiconductor junction devices of the present invention can be constructed and used in a number of different ways in addition to those shown in Figures 14 through 16. For example, the ability to make proximity doped p-n junctions, such as shown in Figure 14A, makes it possible to make bipolar transistors using proximity doped amorphous materials. In addition, such proximity doped junction devices could be made by placing a proximity doped amorphous semiconductor in contact with a metal having a different Fermi level, so as to form a Schottky diode.

Modifications and variations of the present invention are possible in view of the above teachings. For example, the charged bodies used for proximity doping in the present invention need not be in the form of a layer, but also could be in the form of small regions of charged material deposited throughout the amorphous semiconductor material which they are used to proximity dope. Similarly it should be clear that the charged bodies used in the present invention can be made of a variety of materials, so long as they are either deposited with a net electrical charge or develop a net electrical charge upon their formation in the thin film transistor in which they are being used.

-43-

In addition it should be understood that the charged bodies of the present invention can be used to proximity dope amorphous semiconductor materials other than substantially intrinsic ones. For example, such proximity doping could be used with amorphous semiconductor materials which have undergone atomic impurity doping to make them p-type or n-type. The proximity doping of the present invention could be used to make such p-type materials more p-type and to make n-type materials more n-type. One use of such combined impurity and proximity doping would be to produce field effect transistor channel regions which were sufficiently n-type or p-type so as to conduct without the requirement of a gate voltage, and thus which would require a gate voltage to turn them off.

It is therefore to be understood that within the scope of the appended claims the invention can be practiced otherwise then as specifically described.

Case 738 ‑ 0166261 ‑

-44-
<u>CLAIMS</u>

Claim 1.  A field effect transistor (10;50;80;110;140;170;232,234;272,274;310) of the type which includes, a source (22;56;88;120;144;174;240,244;284,296;318); a drain (24;58;90;121;146;176;242;286,298;320); a channel region (20;55;98;126;160;184;265,266;304,306;328,330) of amorphous semiconductor material in which a conduction channel can be formed between the source and drain; and a gate (30;60,78;82;112;154;188;254,256;278,302;324,326) adapted, in response to an applied voltage, to induce a change in the conductivity of the channel region, characterized by,

a field inducing body (16,26;66,68,70;94;124;158;192;246,248;288,292;312) of material, formed with a built-in charge, in field effect proximity to the channel region so as to shift the Fermi level thereof by means of a field effect rather than by atomic impurity doping.

Claim 2.  The field effect transistor (10;50;80;110;140;170;232,234;272,274;310) of Claim 1, further characterized by:

the channel region (20;55;98;126;160;184;265,266;304,306;328,330) being formed of a substantially intrinsic amorphous semiconductor material; and

the built-in charge of the field inducing body (16,26;66,68,70;94;124;158;192;246,248;288,292;312) shifting the Fermi level of the channel region to make it either an n-type or a p-type semiconductor.

Claim 3.  The field effect transistor (10;50;80;110;140;170;232,234;272,274;310) of Claim 1, further characterized by the built-in charge of the

-45-

field inducing body
(16,26;66,68,70;94;124;158;192;246,248;288,292;312)
shifting the Fermi level of the channel region
(20;55;98;126;160;184;265,266;304,306;328,330) so less
voltage has to be applied to the gate
(30;60,78;82;112;154;188;254,256;278,302;324,326) to
switch the channel region from a substantially
non-conducting to a substantially conducting state.

Claim 4.  The field effect transistor
(10;50;80;110;140;170;232,234;272,274;310) of Claim 1,
further characterized by the built-in charge of the
field inducing body
(16,26;66,68,70;94;124;158;192;246,248;288,292;312)
shifting the Fermi level of the channel region
(20;55;98;126;160;184;265,266;304,306;328,330) so the
channel region becomes substantially conducting in the
absence of any voltage applied to the gate
(30;60,78;82;112;154;188;254,256;278,302;324,326), and
so a voltage must be applied to the gate to make the
channel region substantially non-conducting.

Claim 5.  The field effect transistor
(10;50;80;110;140;170;232,234;272,274;310) of Claim 1,
further characterized by having a body
(18;72,74;92;118;148;182;238;282,294;316) of amorphous
semiconductor material in which the channel region
(20;55;98;126;160;184;265,266;304,306;328,330) is
located, and by the field inducing body
(16,26;66,68,70;94;124;158;192;246,248;288,292;312)
being in contact with said body of amorphous
semiconductor material.

Claim 6.  The field effect transistor
(10;50;80;110;140;170;232,234;272,274;310) of Claim 5,
further characterized by:

the body
(18;72,74;92;118;148;182;238;282,294;316) of amorphous
semiconductor material and the field inducing body

0166261

-46-

(16,26;66,68,70;94;124;158;192;246,248;288,292;312)
each being made of layers of deposited material;

one of said two layers being deposited in
contact with the other, and

the built-in charge of the field inducing
layer being formed in the creation of such layers.

Claim 7.   The field effect transistor
(10;50;80;110;140;170;232,234;272,274;310) of Claim 6,
further characterized by said field inducing layer
(16,26;66,68,70;94;124;158;192;246,248;288,292;312)
being  formed of an intrinsically charging material of
the type which forms independently of the addition to
such material of any impurity doping atoms, a built-in
charge when a layer of such intrinsic material and the
layer (18;72,74;92;118;148;182;238;282,294;316) of
amorphous semiconductor material are deposited, one in
contact with the other.

Claim 8.   The field effect transistor
(10;50;80;110;140;170;232,234;272,274;310) of Claim 7,
further characterized by the intrinsically charging
material
(16,26;66,68,70;94;124;158;192;246,248;288,292;312)
being an alloy of amorphous silicon including a member
chosen from the group consisting essentially of:
carbon, hydrogen, nitrogen, fluorine and mixtures
thereof.

Claim 9.   The field effect transistor
(10;50;80;110;140;170;232,234;272,274;310) of Claim 8,
further characterized by the intrinsically charging
material
(16,26;66,68,70;94;124;158;192;246,248;288,292;312)
being an amorphous silicon carbide alloy having the
general formula amorphous Si:C:H.

Claim 10.   The field effect transistor

0166261

-47-

(10;50;80;110;140;170;232,234;272,274;310) of Claim 8, further characterized by the intrinsically charging material (16,26;66,68,70;94;124;158;192;246,248;288,292;312) being an amorphous silicon nitride alloy having the general formula amorphous Si:N:H.

Claim 11. The field effect transistor (10;50;80;110;140;170;232,234;272,274;310) of Claim 7, further characterized by the field inducing layer (16,26;66,68,70;94;124;158;192;246,248;288,292;312) having impurity doping atoms added to it so that the built-in charge formed on the field inducing layer has in addition to charged formed independently of the addition of such impurity doping atoms, a significant charge resulting from charge transfer between the field inducing layer and the layer (18;72,74;92;118;148;182;238;282,294;316) of amorphous semiconductor material caused by the presence of such impurity doping atoms.

Claim 12. The field effect transistor (10;50;80;110;140;170;232,234;272,274;310) of Claim 6, further characterized by the field inducing body (16,26;66,68,70;94;124;158;192;246,248;288,292;312) being made of a material which is an electrical insulator.

Claim 13. The field effect transistor (10;50;80;110;140;170;232,234;272,274;310) of Claim 6, further characterized by the field inducing body (16,26;66,68,70;94;124;158;192;246,248;288,292;312) being formed of a layer between 10 and 100 Angstroms thick.

Claim 14. The field effect transistor (10;50;140;170;232;234) of Claim 5, further characterized by:

the transistor including a gate insulator (28;64,76;152;186;250,252) located between the channel

-48-

region (20;55,160;184;265,266) and the gate (30;60,78;154;188;254,256); and

the field inducing body (26;66,70;158;192;246,248) being formed in a layer located between the channel region and the gate insulator.

Claim 15. The field effect transistor (10;50;80;110;272,274;310) of Claim 5, further characterized by:

the transistor including a layer (28;64,76;86;116;280,300;322) of gate insulator located between the channel region (20;55;98;126;304,306;328,330) and the gate (30;60,78;82;112;278;302;324,326), and further including a layer (18;52,54;92;118;282;294;316) of amorphous semiconductor material in which the channel region is located; and

the field inducing body (16;68;94;124;288,292;312) being formed in a layer located on the opposite side of the layer of amorphous semiconductor material from the layer of gate insulator.

Claim 16. The field effect transistor (10;50;80) of Claim 15, further characterized by including a second field inducing body (26;66,70;100) in the form of a layer, formed with a built-in charge, said second field inducing body being located between the layer (18;52,54;92) of amorphous semiconductor material and the gate insulator (28;64,76;86) so as to be in field effect proximity to the channel region (20;55;98) and thus aid in shifting the Fermi level thereof by means of a field effect rather than by atomic impurity doping.

Claim 17. The field effect transistor (310) of Claim 1, further characterized by:

-49-

said gate being comprised of a plurality of separate, variably chargeable gate electrodes (324,326), each of which is capable of inducing a change in the conductivity of a corresponding separate portion (328,330) of the channel region located in field effect proximity to it, and

said conduction channel (328,330) being formed all the way between the source (318) and drain (320) only when each of the portions of the channel region corresponding to each of the separate gate electrode is conductive.

Claim 18. The field effect transistor (10;50;80;110;140;170;232,234;272,274;310) of Claim 1, further characterized by the channel region (20;55;98;126;160;184;265,266;304,306;328,330) being formed of an amorphous alloy of silicon.

Claim 19. The field effect transistor (10;50;80;110;140;170;232,234;272,274;310) of Claim 1, further characterized by the channel region (20;55;98;126;160;184;265,266;304,306;328,330) being formed of an amorphous alloy of germanium.

Claim 20. The field effect transistor (10;50;80;110;140;170;232,234;272,274;310) of Claim 1, further characterized by the channel region (20;55;98;126;160;184;265,266;304,306;328,330) being formed of an amorphous alloy of silicon and germanium.

Claim 21. The field effect transistor (10;50;80;110;140;170;232,234;272,274;310) of Claim 1 further characterized by:

said channel region (20;55;98;126;160;184;265,266;304,306;328,330) being formed in a channel layer (18;72,74;92;118;148;182;238;282,294;316) of deposited thin film of amorphous semiconductor, and

including a gate insulator (28;64,76;86;116;152;186;250;252;280,300;322) for

-50-

electrically insulating the gate
(30;60,78;82;112;154;188;254,256;278,302;324,326) from
the channel layer.

Claim 22. The thin film field effect
transistor (50) of Claim 21 further characterized by:

having a plurality of said channel layers
(52,54), each having a channel region (55) in which a
conductive channel can be formed, and one or more of
said field inducing layers (66,68,70), each formed
with a built-in charge, located so that each channel
layer has at least one field inducing layer in field
effect proximity to it so as to shift the Fermi level
of the channel region of that layer by means of a
field effect rather than by atomic impurity doping;
and

the plurality of channel layers being arrayed
one on top of the other, with a field inducing layer
(68) between each adjacent pair of channel layers, to
form a multilayered structure comprised of said
channel layers and said one or more field inducing
layers.

Claim 23. The thin film field effect
transistor (80;110) of Claim 21, having a substrate
(84;114), further characterized by:

the gate (82;112) being formed of conductive
material on the substrate;

the gate insulator (86;116) being formed in a
layer overlying the gate;

the source (88;120) and drain (90;121)
electrodes being disposed over the gate insulator in
non-overlapping relation to each other so as to be
separated from each other by a gap;

and the channel layer (92;118) being disposed
over the gate insulator, extending between the source
and drain.

-51-

Claim 24. The thin film field effect transistor (80;110) of Claim 23 further characterized by:

one of the two layers of deposited materials, either the channel layer (92;118) or the field inducing layer (94,100;124), being deposited in contact with the other; and

the built-in charge of the field inducing layer being formed in the creation of such layers.

Claim 25. The thin film field effect transistor (80;110) of Claim 23, further characterized by the gate insulator (86;116) being formed of an oxide which has been annealed after its deposition upon the gate (82;112) and before the deposition of the channel layer (92;118) at a temperature of at least 400 degrees centigrade.

Claim 26. The thin film field effect transistor (110) of Claim 23, further characterized by:

the gate (112) having a first non-coplanar surface (128) with respect to the substrate (114);

the layer (116) of the gate insulator which overlies the gate having a non-coplanar surface (130) which overlies the first non-coplanar surface of the gate;

the channel layer (118) and the conduction channel (126) which can be formed in it extending across a portion of the second non-coplanar surface; and

the source (120) and drain (121) being formed on generally opposite sides of the non-coplanar surface (128).

Claim 27. The thin film field effect transistor (140) of Claim 21, further characterized by:

the transistor being formed on a substantially horizontal substrate (142) and being comprised of a plurality of substantially horizontal

0166261

-52-

layers (146,148,144) vertically arrayed with respect to the substrate and to each other, including a layer (144) forming the source, a layer (146) forming the drain, and the channel layer (148) between the source and drain layers;

at least portions of the edges of the plurality of layers forming a non-coplanar surface (150) with respect to the substrate;

the gate insulator (152) overlying at least a portion of the non-coplanar surface; and

the gate (154) being placed over the gate insulator.

Claim 28. The thin film field effect transistor (140) of Claim 27 further characterized by:

one of the two layers of deposited materials, either the channel layer (148) or the field inducing layer (158), being deposited in contact with the other; and

the built-in charge of the field inducing layer being formed in the creation of such layers.

Claim 29. The thin film field effect transistor (170) of Claim 21, further characterized by:

the transistor being formed on a substantially horizontal substrate (172) and being comprised of a plurality of substantially horizontal layers (174,176,178) vertically arrayed with respect to the substrate and to each other, including a layer (174) forming the source, a layer (176) forming the drain, and an electrically insulating layer (178) between the source and drain layers;

at least portions of the edges of the plurality of layers forming a non-coplanar surface (180) with respect to the substrate;

the channel layer (182) overlying the non-coplanar surface between, and being in electrical connection with, the source and drain layers so as to

-53-

be able to form the current conduction channel (184) therebetween;

the gate insulator (186) being placed over the channel layer; and

the gate (188) being placed over the gate insulator.

Claim 30. The thin film field effect transistor (170) of Claim 29, further characterized by:

one of the two layers of deposited material, either the channel layer (182) or the field inducing layer (192) being deposited in contact with the other;

and the built-in charge of the field inducing layer being formed in the creation of such layers.

Claim 31. An electronic circuit (200;230;270) of the type having two field effect transistors (202,204;232,234;272,274) each including two current path electrodes, one being a source (206;240,244;284,296) and the other being a drain (208;242;286,298), a channel region (210;265,266;304,306) of amorphous semiconductor material in which a conduction channel can be formed between the source and drain, and a gate (212;254;256;278,302) adapted, in response to an applied voltage, to induce a change in the conductivity of the channel region; of the type having a common input (214;262) and a common output (216;264), with the gates of both transistors responsive to the common input, and one current path electrode of each transistor connected to the common output, and having the other current path electrode of one transistors connected to a relatively positive voltage supply (218;258) and the other current path electrode of the other transistor connected to a relatively negative voltage supply (220;260); and of the type having the channel regions of the two transistors made so that a voltage supplied to the

-54-

common input which turns one transistor on will turn the other transistor off, said circuit characterized by:

a field inducing body (246,248;286,292) of material, in at least one of the two transistors, formed with a built-in charge, in field effect proximity to the channel region of that transistor so as to shift the Fermi level thereof by means of a field effect rather than by atomic impurity doping.

Claim 32. The electronic circuit (200;230;270) of Claim 31, further characterized by the two transistors (202,204;232,234;272,274) being metal-oxide-semiconductor transistors and one of them (204;234;274) being an n-channel transistor and the other (202;232;272) being a p-channel transistor.

Claim 33. The electronic circuit (200;230;270) of Claim 31, further characterized by each of the transistors (202,204;232,234;272,274) comprising:

a field inducing body (246,248;286,292) of material, formed with a built-in charge, in field effect proximity to the channel region (210;265,266;304,306) of that transistor so as to shift the Fermi level thereof by means of a field effect rather than by atomic impurity doping.

Claim 34. The electronic circuit (200;230;270) of Claim 33, further characterized by the channel region (210;265,266;304,306) of the at least one transistor (202,204;232,234;272,274) being formed of a substantially intrinsic amorphous semiconductor material and the built-in charge of its associated field inducing body (246,248;286,292) shifting the Fermi level of that channel region so as to make it either an n-type or a p-type semiconductor.

Claim 35. The electronic circuit (200;230;270) of Claim 31, further characterized by

-55-

the built-in charge of the field inducing body (246,248;286,292) of the at least one transistor (202,204;232,234;272,274) shifting the Fermi level of its associated channel region (210;265,266;304,306) so less voltage has to be applied to the associated gate (212;254;256;278,302) to switch that channel region from a substantially non-conducting to a substantially conducting state.

Claim 36. The electronic circuit (200;230;270) of Claim 31, further characterized by the built-in charge of the field inducing body (246,248;286,292) of the at least one transistor (202,204;232,234;272,274) shifting the Fermi level of its associated channel region (210;265,266;304,306) so that channel region. becomes substantially conducting in the absence of any voltage applied to the associated gate (212;254;256;278,302), and so a voltage must be applied to that gate to make that channel region substantially non-conducting.

Claim 37. The electronic circuit (200;230;270) of Claim 31, further characterized by:

the at least one transistor (202,204;232,234;272,274) having a channel layer (238;282,294) formed of amorphous semiconductor material in which the channel region (210;265,266;304,306) is included;

the associated field inducing body (246,248;286,292) being formed as a field inducing layer;

the channel layer and field inducing layer of the at least one transistor being each made of deposited materials;

one of said two layers being deposited in contact with the other; and

the built-in charge of the field inducing layer being formed in the creation of such layers.

-56-

Claim 38. The electronic circuit (200;230;270) of Claim 37, further characterized by said field inducing layer (246,248;286,292) being formed of an intrinsically charging material of the type which forms, independently of the addition to such material of any impurity doping atoms, a built-in charge when a layer of such intrinsic material and the layer (238;282,294) of amorphous semiconductor material are deposited, one in contact with the other.

Claim 39. The electronic circuit (200;230;270) of Claim 38, further characterized by the intrinsically charging material (246,248;286,292) being an alloy of amorphous silicon including a member chosen from the group consisting essentially of: carbon, hydrogen, nitrogen, fluorine and mixtures thereof.

Claim 40. The electronic circuit (200;230;270) of Claim 39, further characterized by the intrinsically charging material (246,248;286,292) being an amorphous silicon carbide alloy having the general formula amorphous Si:C:H.

Claim 41. The electronic circuit (200;230;270) of Claim 39, further characterized by the intrinsically charging material (246,248;286,292) being an amorphous silicon nitride alloy having the general formula amorphous Si:N:H.

Claim 42. The electronic circuit (200;230;270) of Claim 38, further characterized by the field inducing layer (246,248;286,292) having impurity doping atoms added to it so that the built-in charge includes, in addition to charge formed independently of the addition of such impurity doping atoms, a significant charge resulting from charge transfer between the field inducing layer and the

-57-

layer (238;282,294) of amorphous semiconductor material caused by the presence of such impurity doping atoms.

Claim 43. The electronic circuit (200;230;270) of Claim 31, further characterized by the field inducing body (246,248;286,292) of the at least one transistor (202,204;232,234;272,274) being made of a material which is an electrical insulator.

Claim 44. The electronic circuit (270) of Claim 31, further including a substrate (276), and further characterized by:

both of the two transistors (272,274) being thin film transistors in which the channel region (304,306) is formed of a layer (282,294) of amorphous semiconductor material;

the field inducing body (288,292) being formed in a layer;

and the layers of the channel regions of the two transistors and of the field inducing body being all disposed one on top of the other above, and substantially parallel to, the substrate.

Claim 45. A semiconductor device (340;370;390) characterized by:

a first region (342;408) of material consisting essentially of an amorphous semiconductor material;

a first field inducing layer (344;380;394) of material, formed with a built-in charge, in field effect proximity to said first region so as to proximity dope at least a layer of said semiconductor material in said region parallel to the field inducing layer by shifting the Fermi level thereof toward one band edge, either the conduction or valence band edge, by means of a field effect rather than by atomic impurity doping; and

-58-

a second region (346;410) of material which has its Fermi level positioned further away from said one band edge than that of said material in said first region; and

wherein said first and second regions are in contact with each other so as to form a junction which extends in a direction so as to influence the flow of current which lies within, and runs parallel to, said proximity doped layer.

Claim 46. The semiconductor device (340;390) of Claim 45 further characterized by:

said second region (346;410) of material consisting essentially of an amorphous semiconductor material;

said device further including a second field inducing layer (348;396) of material, formed with a built-in charge of a polarity opposite that of the built-in charge of said first field inducing body (349;394), in field effect proximity to said second region so as to proximity dope at least a layer of semiconductor material in said second region by shifting the Fermi level thereof toward the band edge opposite the band edge toward which the Fermi level of the first region (342;408) is shifted, said shifting of the Fermi level in said second region by said field inducing body being accomplished by means of a field effect rather than by atomic impurity doping; and

said first and second regions being in contact with each other so as to make said junction a p-n junction.

Claim 47. The semiconductor device (390) of Claim 45, further characterized by including a variably chargeable body (406) of material, in field effect proximity to either said first or second region (408) so as to variably alter, by means of a field effect, the amount which the Fermi level in said first

-59-

or second region is shifted toward or away from said one band edge in the vacinity of said junction.

Claim 48. The semiconductor device (340;370;390) of Claim 45, further characterized by:

said device including a single layer of amorphous semiconductor material (342,346;378;402) of which both said first (342;408) and second (346;410) region are part; and

said first field inducing layer (344;380;394) being formed in contact with said first region of said layer.

0166261

FIG 1

FIG 2A

FIG 2B

FIG 3A

FIG 3B

*FIG 4*

*FIG 5*

*FIG 6*

FIG 7

FIG 8

FIG 9

FIG 10

FIG 11

FIG 12

4/6

0166261

FIG 14A

FIG 14B

FIG 14C

FIG 13

FIG 15

FIG 16